# EUROPÄISCHE PATENTANMELDUNG

(11) **EP 3 096 395 A1**
(43) Veröffentlichungstag der Anmeldung: **23.11.2016**
(21) Anmeldenummer: 16168896.5
(22) Anmeldetag: 10.05.2016
(51) Int. Cl.: H01P 5/02, H01P 5/12, H01P 5/18

(54) **COMBINER-ANORDNUNG**

(30) Priorität: 18.05.2015 DE 102015107729
(71) Anmelder: CRYOELECTRA GMBH, 42287 Wuppertal (DE)
(72) Erfinder: Dr. KOLESOV, Sergei, 58285 Gevelsberg (DE); PIEL, DR. Prof., Helmut, 42287 Wuppertal (DE)
(74) Vertreter: Cohausz & Florack

(57) **Zusammenfassung**

Die vorliegende Erfindung betrifft unter anderem eine Combiner-Anordnung (1,1') zum Zusammenführen mehrerer Hochfrequenz-Eingangssignale zu einem Hochfrequenz-Ausgangssignal umfassend: mindestens zwei Primär-Combiner (2) zum Zusammenführen von jeweils mindestens zwei Hochfrequenz-Eingangssignalen zu jeweils einem Hochfrequenz-Zwischensignal und einen Sekundär-Combiner (4) zum Zusammenführen der Hochfrequenz-Zwischensignale der Primär-Combiner zu dem Hochfrequenz-Ausgangssignal. Die Aufgabe, eine kompakte Bauform bei gleichzeitig möglichst geringen Kombinationsverlusten und einfacher Zugänglichkeit der Komponenten zu ermöglichen, wird dadurch gelöst, dass der Sekundär-Combiner (4) einen Koppler (6) zum Zusammenführen der Hochfrequenz-Zwischensignale der Primär-Combiner (2) umfasst.

## Beschreibung

Die vorliegende Erfindung betrifft gemäß einem ersten Aspekt eine Combiner-Anordnung zum Zusammenführen mehrerer Hochfrequenz-Eingangssignale zu einem Hochfrequenz-Ausgangssignal umfassend: mindestens zwei Primär-Combiner zum Zusammenführen von jeweils mindestens zwei Hochfrequenz-Eingangssignalen zu jeweils einem Hochfrequenz-Zwischensignal und einen Sekundär-Combiner zum Zusammenführen der Hochfrequenz-Zwischensignale der Primär-Combiner zu dem Hochfrequenz-Ausgangssignal.

Gemäß einem zweiten Aspekt betrifft die Erfindung ein System umfassend eine Vielzahl von Verstärkereinheiten zur Erzeugung der Hochfrequenz-Eingangssignale.

Gemäß einem dritten Aspekt betrifft die Erfindung ein Verfahren zum Zusammenführen mehrerer Hochfrequenz-Eingangssignale zu einem Hochfrequenz-Ausgangssignal, insbesondere mit einer Combiner-Anordnung gemäß dem ersten Aspekt, umfassend die Schritte: Zusammenführen von jeweils mindestens zwei Hochfrequenz-Eingangssignalen zu jeweils einem Hochfrequenz-Zwischensignal über mindestens zwei Primär-Combiner und Zusammenführen der Hochfrequenz-Zwischensignale der Primär-Combiner zu dem Hochfrequenz-Ausgangssignal über einen Sekundär-Combiner.

Durch die Entwicklung und Weiterentwicklung von LDMOS ("laterally diffused metal oxide semiconductor") FETs (Feldeffekt-Transistoren) wurde die Entwicklung von Hochleistungsverstärkern im Hochfrequenzbereich (insbesondere im VHV und UHF-Bereich) stark vorangetrieben. Beispielsweise können Leistungsverstärkereinheiten aus zwei Transistoren in Gegentaktschaltung (sogenannte "push pull"-Schaltung) mit einer Hochfrequenz-Ausgangsleistung des Transistorpaares von 750 Watt im Frequenzbereich von 50 bis 500 MHz bereitgestellt werden. Dies ist der Frequenzbereich, in dem die Hochfrequenz-Beschleunigungs-Resonatoren nahezu aller kreisförmigen Teilchenbeschleuniger (beispielsweise Synchrotrons und Zyklotrons) betrieben werden. Zum Aufbau und Erhalt der elektrischen Beschleunigungsfelder in diesen Resonatoren werden Hochfrequenzleistungen von typischerweise 150kW bis 300kW benötigt.

Solche hohen Leistungen können mit Halbleiterverstärkern allerdings nur dann erreicht werden, wenn die Ausgangssignale von mehr als hundert Verstärkereinheiten (sogenannte "Amplifier Units" oder AU) mit Hilfe von Combinern zusammengeführt werden. Geht man beispielsweise davon aus, dass mit einer solchen Verstärkereinheit nach dem heutigen Stand der Technik eine Hochfrequenz-Leistung von ca. 625 W erzeugt werden kann, dann können vier dieser Verstärkereinheiten zwar bereits eine Leistung von 2,5 kW bereitstellen. Aber um schließlich die oben angesprochenen gewünschte Ausgangsleistungen, beispielsweise von 150kW, zu erzielen, benötigt man dann immer noch einen Sechzigfach-Combiner, das heißt einen Combiner der 60 Einzelsignale zu einem Ausgangssignal zusammenführt. Ein Zusammenführen dieser Signale ist aufgrund der hohen Leistungen in Planartechnik nicht mehr möglich.

Daher geschieht das Zusammenführen nach dem heutigen Stand der Technik im Hochfrequenzbereich durch ein System von Wellenleitern für elektromagnetische Wellen, d.h. räumlichen Strukturen, in denen sich elektromagnetische Wellen geführt ausbreiten können. Solche Wellenleiter können beispielsweise als koaxiale Leiter mit einem Innenleiter und einem Außenleiter oder als Hohlleiter ausgebildet sein. Koaxial-Combiner werden insbesondere im VHF-Bereich ("Very High Frequency", Frequenzen von 30MHz bis 300MHz) eingesetzt, während insbesondere im UHF-Bereich ("Ultra High Frequency", Frequenzen von 300 MHz bis 3 GHz) aufgrund der Leistungsverluste etwa in koaxialen Kabeln Wellenleiter- bzw. Hohlleiter-Combiner eingesetzt werden.

Im VHF-Bereich bestehen die Signale aus elektromagnetischen Wellen mit (Vakuum-)Wellenlängen von etwa 1m bis 10m. Da die Komponenten entsprechender VHF-Koaxial-Combiner in der Größenordnung der Wellenlänge liegen (beispielsweise bei λ/4-Transformatoren), können VHF-Koaxial-Combiner unpraktisch lang werden und entsprechend viel Raum beanspruchen.

Beispielsweise ist aus der deutschen Patentschrift DE 10 2013 102 552 B3 eine gattungsgemäße Combiner-Anordnung bekannt, welche mehrere Hochfrequenz-Eingangssignale zu einem Hochfrequenz-Ausgangssignal zusammenführt. Dabei werden die zusammenzuführenden Signale in mehreren Stufen über Combiner zusammengeführt. Hierbei sind zwei Sätze von länglichen Primär-Combiner vorgesehen, welche jeweils Wagenrad-ähnlich bzw. sternförmig in einer Ebene angeordnet sind und mittig zu jeweils einem Sekundär-Combiner führen, welcher senkrecht zu den Primär-Combinern angeordnet ist. Die Leistung der Sekundär-Combiner wird dann über einen weiteren Combiner ausgekoppelt. Zwar kann durch die kreisförmige Anordnung der Schaltschränke eine einfache Zugänglichkeit erreicht werden. Dies führt aber zu einer vergleichsweise raumgreifenden Anordnung.

Es wäre beispielsweise denkbar, eine Combiner-Anordnung mit einer radialen Geometrie (das heißt einem Combiner, welcher Signale durch einen scheibenförmigen Wellenleiter des Combiners radial nach innen führt, um sie zu vereinigen) vorzusehen. Die Signale werden beispielsweise an symmetrisch über einen Randbereich des scheibenförmigen Wellenleiters verteilten Positionen eingekoppelt und im Zentrum des scheibenförmigen Wellenleiters ausgekoppelt. Um dabei unerwünschte Reflektionen zu vermeiden, könnte eine konische (vom Rand zum Zentrum ansteigende) Bodenplatte in Kombination mit einer planaren Deckenplatte des scheibenförmigen Wellenleiters vorgesehen werden. Man kann sich den scheibenförmigen Wellenleiter dabei modellhaft in Segmente unterteilt vorstellen, wobei jeweils ein eingekoppeltes Signal durch ein Wellenleitersegment propagiert und anschließend ausgekoppelt wird. Die Modellvorstellung kann durch Überlegungen zum auftretenden Stromfluss motiviert werden. In dieser Modellvorstellung wird für die radial nach innen propagierenden Signale nicht nur die Breite des Wellenleitersegments (das sich also als das jeweilige Segment des scheibenförmigen Wellenleiters, welchem Segment ein in den Wellenleiter eingekoppeltes Signal zugeordnet ist, darstellt) sondern auch dessen Höhe verringert. Da der Leitungswellenwiderstand eines derartigen Wellenleitersegments proportional zum Verhältnis von Höhe zu Breite der Wellenleitergeometrie ist, kann durch die Konizität (also die zum Zentrum des Wellenleiters hin abnehmende Höhe) der Bodenplatte eine Reduzierung der Breite des Wellenleitersegments zu dessen Zentrum hin ausgeglichen werden und der Leitungswellenwiderstand bleibt in radialer Richtung konstant. Somit könnten unerwünschte Reflektionen durch Fehlanpassungen vermieden werden. Da der Leitungswellenwiderstand jedoch in der Regel durch λ/4-Transformatoren angepasst werden muss, würde dies zu Combiner-Anordnungen führen, die im beschriebenen VHF-Bereich bereits Durchmesser von mehreren Metern haben können. Beispielsweise müsste ein scheibenförmiger Parallelplatten-Wellenleiter (mit konischer Bodenplatte) bei einer Frequenz von etwa 70 MHz schon einen Durchmesser (2*r) von mehr als 2m (2*λ/4) haben. Derartige Geometrien wären daher nur bei vergleichsweise hohen Frequenzen (etwa bei Mikrowellen) platzsparend zu realisieren.

Es besteht daher insbesondere das Bedürfnis, den Platzbedarf der Combiner weiter zu verringern. Dabei soll jedoch weiterhin ein Zugang zu den einzelnen Verstärkereinheiten möglich bleiben, sodass ein einfacher Austausch der Verstärkereinheiten möglich ist. Zudem müssen die Kombinationsverluste möglichst gering gehalten werden, um einen möglichst hohen Wirkungsgrad zu erzielen.

Vor diesem Hintergrund stellt sich der Erfindung die Aufgabe, eine Combiner-Anordnung, ein System und ein Verfahren vorzuschlagen, wobei eine kompakte Bauform bei gleichzeitig möglichst geringen Kombinationsverlusten und einfacher Zugänglichkeit der Komponenten ermöglicht wird.

Die Aufgabe wird bei einer Combiner-Anordnung gemäß dem ersten Aspekt dadurch gelöst, dass der Sekundär-Combiner einen Koppler zum Zusammenführen der Hochfrequenz-Zwischensignale der Primär-Combiner umfasst.

Bei einem System gemäß dem zweiten Aspekt wird die Aufgabe dadurch gelöst, dass das System eine Combiner-Anordnung gemäß dem ersten Aspekt umfasst.

Bei einem Verfahren gemäß dem dritten Aspekt wird die Aufgabe dadurch gelöst, dass die Hochfrequenz-Zwischensignale der Primär-Combiner über einen Koppler des Sekundär-Combiners zusammengeführt werden.

Im Stand der Technik wurde bisher davon ausgegangen, dass ein Zusammenführen der bereits durch die Primär-Combiner zu Hochfrequenz-Zwischensignalen zusammengeführten Hochfrequenz-Eingangssignale über einen platzsparenden Koppler, etwa mit einer scheibenförmigen Geometrie, nicht möglich ist. Dies liegt daran, dass durch das Zusammenführen auf der zweiten Combiner-Stufe bereits ein vergleichsweise großer Koppler zum Einsatz kommen muss, um die Hochfrequenz-Signale insbesondere bei hohen Leistungen zusammenzuführen. Dabei ist vor allem problematisch, dass die Leitungswellenwiderstände bei der Verwendung derartiger Koppler, wenn sie entsprechend platzsparend ausgeführt werden sollen, analytisch nicht mehr berechenbar sind. Werden mehrere Hochfrequenz-Zwischensignale durch den Koppler des Sekundär-Combiners geleitet, beispielsweise von außen nach innen, wird ein Hochfrequenz-Zwischensignal effektiv in einem spitz zulaufenden Kopplersegment von außen nach innen geleitet. Man war davon ausgegangen, dass derartige Geometrien des Sekundär-Combiners bei großen Dimensionierungen des Kopplers (im Vergleich zur Wellenlänge der Hochfrequenz-Signale gesehen), wie sie für einen Sekundär-Combiner bei Hochfrequenz-Signalen notwendig sind, nicht zu einem effektiven Zusammenführen der Hochfrequenz-Zwischensignale genutzt werden kann. Zudem ist eine ausreichende Berechnung der Eigenschaften derartiger Geometrien nicht möglich.

Die Aspekte der Erfindung wenden sich gegen diese Annahmen aus dem Stand der Technik. Es hat sich gezeigt, dass durch einen Sekundär-Combiner, welcher einen Koppler zum Zusammenführen der Hochfrequenz-Zwischensignale der Primär-Combiner umfasst, nicht nur eine kompakte Bauform bei einfacher Zugänglichkeit der Verstärkereinheiten ermöglicht werden kann, sondern vor allem entgegen den Erwartungen auch gleichzeitig geringe Kombinationsverluste erreicht werden können.

Hierzu kann die Combiner-Anordnung oder Teile hiervon beispielsweise simuliert werden, beispielsweise mittels einer Finite-Elemente-Methode (FEM). Hierdurch kann die konkrete Geometrie des Kopplers zum Zusammenführen der Hochfrequenz-Zwischensignale der Primär-Combiner im Einzelfall bestimmt werden.

Durch das Vorsehen eines Kopplers kann insbesondere eine kabelfreie Verbindung zwischen den Primär-Combinern und dem Koppler des Sekundär-Combiners vorgesehen werden. Beispielsweise sind die Primär-Combiner auf den Koppler geflanscht.

Unter einem Combiner wird, wie auch in der Hochfrequenztechnik, vorliegend eine Baugruppe verstanden, welche mehrere schwächere Signale, insbesondere gleicher Frequenz, zu einem stärkeren Signal zusammenfügt. Bevorzugt isoliert der Combiner dabei seine Eingänge voneinander, so dass diese sich nicht gegenseitig beeinflussen, beziehungsweise die jeweils anderen Signalerzeuger, welche die Hochfrequenz-Eingangssignale bereitstellen.

Unter Hochfrequenz wird, wie auch in der Elektrotechnik, der Frequenzbereich von 9 kHz bis zum langwelligen Licht (THz-Bereich) bezeichnet. Es sollen also insbesondere auch der VHF-Bereich (Very High Frequency, zu Deutsch auch Ultrakurzwelle/UKW) mit Frequenzen von 30MHz bis 300MHz (bzw. Wellenlängen von etwa 10m bis 1m) und der UHF-Bereich (Ultra High Frequency) mit Frequenzen von 300MHz bis 3GHz (bzw. Wellenlängen von 1m bis 10cm) umfasst sein.

Im Folgenden sollen weitere vorteilhafte Ausgestaltungen für die unterschiedlichen Aspekte der Erfindung erläutert werden.

Gemäß einer Ausgestaltung der unterschiedlichen Aspekte der Erfindung ist der Koppler des Sekundär-Combiners scheibenförmig ausgeführt. Dabei kann der Koppler des Sekundär-Combiners beispielsweise in Form einer Kreisscheibe ausgeführt sein. Hierunter wird insbesondere ein flächiger Zylinder verstanden, insbesondere ein Zylinder, dessen Radius deutlich (beispielsweise um ein Vielfaches, beispielsweise mindestens zweimal) höher ist als dessen Dicke (beispielsweise in Form einer Dose). Ebenfalls ist jedoch denkbar, dass der Koppler des Sekundär-Combiners als mehreckige Scheibe, beispielsweise (gerades) Prisma mit einem Vieleck (beispielsweise einem Viereck, Sechseck Achteck, etc.) als Grundfläche ausgeführt ist. Der Koppler kann also beispielsweise als Quader ausgebildet sein.

Gemäß einer bevorzugten Ausgestaltung der unterschiedlichen Aspekte der Erfindung ist der Sekundär-Combiner insbesondere durch seine Geometrie derart ausgelegt, dass eine zumindest teilweise Kompensation von im Sekundär-Combiner reflektierten Hochfrequenz-Signalen erreicht wird. Bevorzugt werden dabei die (beispielsweise aufgrund der Geometrie des Kopplers) im Sekundär-Combiner reflektierten Hochfrequenz-Signale durch eine weitere Reflektion von Hochfrequenz-Signalen im Sekundär-Combiner kompensiert.

Unter einer Kompensation wird insbesondere verstanden, dass verschiedene Einflüsse einer physikalischen Größe (z.B. eines Hochfrequenz-Signals) durch technische Gegebenheiten oder ihre Ausgestaltung (z.B. durch die Geometrie und physikalischen Eigenschaften der Combiner-Anordnung) so gegeneinander wirken, dass diese sich aufheben. Wird ein Einfluss als Störung bewertet (wie beispielsweise ein zurück in den Primär-Combiner reflektiertes Hochfrequenz-Signal), so ist es das Ziel der Kompensation, dem unerwünschten Einfluss einen zweiten entgegenzustellen, der den ursprünglichen Einfluss aufheben oder reduzieren soll.

Auf diese Weise kann erreicht werden, dass eine Reflektion von Signalen zurück in die Primär-Combiner zumindest teilweise (oder vollständig) unterbunden wird. Das heißt, obwohl eine (unerwünschte oder unvermeidbare) Reflektion von Hochfrequenz-Signalen im Sekundär-Combiner erfolgt, sieht oder spürt der Primär-Combiner diese Reflektionen nicht oder nur reduziert. Dadurch kann insbesondere eine effiziente Isolierung der Combiner-Eingänge voneinander erfolgen und ein hoher Wirkungsgrad der Combiner-Anordnung erreicht werden. Beispielsweise wird eine unerwünschte oder (z.B. aufgrund der Geometrie des Kopplers, die eine Änderung des Wellenwiderstands entlang der Signalausbreitungswege bedingt) unvermeidbare Reflektion von Hochfrequenz-Signalen im Sekundär-Combiner durch eine gezielte oder absichtliche (aber grundsätzlich vermeidbare) weitere Reflektion von Hochfrequenz-Signalen im Sekundär-Combiner kompensiert.

Die reflektierten Hochfrequenz-Signale können beispielsweise (teilweise) reflektierte Hochfrequenz-Zwischensignale und/oder Hochfrequenz-Ausgangssignale sein. Beispielsweise ist ein erstes reflektiertes Hochfrequenz-Signal ein an einer ersten Stelle oder in einem ersten Bereich (beispielsweise im Bereich des Kopplers) des Sekundär-Combiners reflektiertes Hochfrequenz-Signal und ein weiteres reflektiertes Hochfrequenz-Signal ein an einer zweiten Stelle oder einem zweiten Bereich des Sekundär-Combiners reflektiertes Hochfrequenz-Signal.

Es hat sich gezeigt, dass beispielsweise bei einem Koppler, bei dem die Hochfrequenz-Zwischensignale radial nach innen laufen, sich also in Richtung des Mittelpunkts des Kopplers ausbreiten, eine kontinuierliche Reflektion dieser Signale bei der Propagation erfolgt. Durch eine weitere Reflektion des Hochfrequenz-Ausgangssignals im Sekundär-Combiner, kann beispielsweise erreicht werden, dass diese kontinuierliche Reflektion zumindest teilweise kompensiert wird.

Beispielsweise heben sich die Einflüsse der reflektierten Hochfrequenz-Signale an einer (weiteren) Stelle oder in einem (weiteren) Bereich auf, wenn die reflektierten Hochfrequenz-Signale destruktiv interferieren, beispielsweise am jeweiligen Übergangsbereich der Primär-Combiner zum Sekundär-Combiner.

Die Kompensation kann beispielsweise durch eine gezielte Anpassung des Sekundär-Combiners erfolgen. Beispielsweise erfolgt eine gezielte Anpassung oder Änderung des Leitungswellenwiderstandes des Sekundär-Combiners. Jede Veränderung des Wellenwiderstandes im Sekundär-Combiner verursacht eine Reflektion. Die Änderung wird dann gerade so gestaltet, dass hierdurch eine reflektierte Welle erzeugt wird, die im Übergangsbereich der jeweiligen Primär-Combiner zu dem Sekundär-Combiner die dort ebenfalls auftreffende reflektierte Welle, welche durch die Propagation der Hochfrequenz-Signale durch den Koppler erzeugt wird, durch Interferenz kompensiert. Hierzu erfolgt beispielsweise eine Anpassung oder Änderung der Geometrie (beispielsweise der Länge) des Sekundär-Combiners. Beispielsweise erfolgt eine Anpassung oder Änderung der Geometrie des Außenleiters oder des Innenleiters des Sekundär-Combiners (beispielsweise durch eine Querschnittsänderung). Hierdurch kann die beschriebene gezielte Reflektion des Hochfrequenz-Ausgangssignals erfolgen, welche die reflektierten Hochfrequenz-Zwischensignale (teilweise) kompensieren kann.

Gemäß einer bevorzugten Ausgestaltung der unterschiedlichen Aspekte der Erfindung ist zumindest eine charakteristische geometrische Ausdehnung des Kopplers des Sekundär-Combiners im Vergleich zu der Wellenlänge der Hochfrequenz-Eingangssignale und/oder des Hochfrequenz-Ausgangssignals nicht vernachlässigbar.

Unter einer charakteristischen geometrischen Ausdehnung wird beispielsweise der Durchmesser oder der Radius des Kopplers des Sekundär-Combiners verstanden. Unter einer im Vergleich zu der Wellenlänge vernachlässigbaren Ausdehnung wird insbesondere verstanden, dass die Ausdehnung für eine oder mehrere relevante Eigenschaften der Combiner-Anordnung (insbesondere geringe Kombinationsverluste bzw. einen hohen Wirkungsgrad) im Wesentlichen keine oder nur eine im Vergleich zu anderen Einflussfaktoren eine nur untergeordnete Bedeutung besitzt oder keine entscheidende Rolle spielt.

Für den Fall, dass der Koppler des Sekundär-Combiners (kreis-)scheibenförmig ausgebildet ist, beträgt der Radius des Kopplers des Sekundär-Combiners beispielsweise mindestens 2%, bevorzugt mindestens 5%, weiter bevorzugt mindestens 7% der Wellenlänge der Hochfrequenz-Eingangssignale und/oder des Hochfrequenz-Ausgangssignals. Beispielsweise beträgt der Radius des scheibenförmigen Kopplers des Sekundär-Combiners mindestens 10cm, bevorzugt mindestens 20cm, besonders bevorzugt mindestens 30cm.

Wie bereits ausgeführt, hat sich gezeigt, dass trotz der nicht zu vernachlässigenden Größe des Kopplers des Sekundär-Combiners eine kompakte Combiner-Anordnung mit unerwartet niedrigen Kombinationsverlusten bereitgestellt werden kann.

Gemäß einer bevorzugten Ausgestaltung der unterschiedlichen Aspekte der Erfindung sind die Primär-Combiner jeweils im Wesentlichen länglich ausgebildet, wobei die Primär-Combiner vorzugsweise im Wesentlichen parallel verlaufen und/oder im Wesentlichen senkrecht auf dem Koppler des Sekundär-Combiners stehen.

Durch eine derartige Ausgestaltung der Primär-Combiner wird in Kombination mit dem Koppler des Sekundär-Combiners eine besonders kompakte Anordnung erreicht. Ein jeweiliger Primär-Combiner stellt dabei einen im Wesentlichen länglichen Wellenleiter zur Leitung der Hochfrequenz-Zwischensignale von einem dem Koppler des Sekundär-Combiners abgewandten Ende des Primär-Combiners zu einem dem Koppler des Sekundär-Combiners zugewandten Ende des Primär-Combiners dar. Die Primär-Combiner weisen beispielsweise zumindest abschnittsweise einen im Wesentlichen runden Querschnitt auf und sind beispielsweise zumindest abschnittsweise im Wesentlichen zylindrisch ausgebildet.

Gemäß einer bevorzugten Ausgestaltung der unterschiedlichen Aspekte der Erfindung weist der Sekundär-Combiner einen im Wesentlichen länglichen Leitungsabschnitt auf, welcher vorzugsweise im Wesentlichen parallel zu den Primär-Combiner verläuft und/oder im Wesentlichen senkrecht auf dem Koppler des Sekundär-Combiners steht.

Durch eine derartige Ausgestaltung des Sekundär-Combiners wird der Raumbedarf der Combiner-Anordnung weiterhin verringert. Der im Wesentlichen längliche Leitungsabschnitt kann vorteilhaft zur Leitung des Hochfrequenz-Ausgangssignals dienen. Beispielsweise dient der im Wesentlichen längliche Leitungsabschnitt zur Leitung des Hochfrequenz-Ausgangssignals von einem dem Koppler des Sekundär-Combiners zugewandten Ende zu einem dem Koppler des Sekundär-Combiners abgewandten Ende des im Wesentlichen länglichen Leitungsabschnitts des Sekundär-Combiners. Zudem kann der im Wesentlichen längliche Leitungsabschnitt des Sekundär-Combiners vorteilhaft zur Auskopplung des Ausgangssignals aus dem Sekundär-Combiner dienen. Weiterhin kann der im Wesentlichen längliche Leitungsabschnitt auch zur Anpassung des Leitungswellenwiderstandes dienen. Hierzu kann beispielsweise ein Transformatorabschnitt (beispielsweise ein λ/4-Transformator) vorgesehen sein. Dadurch kann der Wirkungsgrad der Combiner-Anordnung gesteigert werden.

Der im Wesentlichen längliche Leitungsabschnitt des Sekundär-Combiners weist beispielsweise zumindest abschnittsweise einen im Wesentlichen runden Querschnitt auf und ist beispielsweise zumindest abschnittsweise im Wesentlichen zylindrisch ausgebildet. Der im Wesentlichen längliche Leitungsabschnitt des Sekundär-Combiners ist beispielsweise länger als die im Wesentlichen länglichen Primär-Combiner. Der im Wesentlichen längliche Leitungsabschnitt des Sekundär-Combiners ist beispielsweise auf den Koppler des Sekundär-Combiners geflanscht.

Besonders bevorzugt sind die Primär-Combiner und der im Wesentlichen längliche Leitungsabschnitt des Sekundär-Combiners auf der gleichen Seite des Kopplers des Sekundär-Combiners angeordnet. Damit wird das Platzerfordernis der Combiner-Anordnung weiter reduziert. Zudem können zur einfachen Zugänglichkeit die Hochfrequenz-Eingangssignale auf derjenigen Seite des Kopplers des Sekundär-Combiners eingekoppelt werden, auf der auch das Hochfrequenz-Ausgangssignal ausgekoppelt werden kann. Es ist jedoch auch denkbar, dass der im Wesentlichen längliche Leitungsabschnitt des Sekundär-Combiners auf einer ersten Seite des Kopplers des Sekundär-Combiners angeordnet ist und die Primär-Combiner ausschließlich (oder zusätzlich zu Primär-Combinern auf der ersten Seite) auf einer der ersten Seite gegenüberliegenden zweiten Seite des Kopplers des Sekundär-Combiners angeordnet sind. Die auf der zweiten Seite angeordneten Primär-Combiner verlaufen dann beispielsweise antiparallel zum Sekundär-Combiner.

In Bezug auf die bereits erwähnte zumindest teilweise Kompensation von im Sekundär-Combiner reflektierten Hochfrequenz-Signalen, kann beispielsweise eine (unerwünschte) erste (zumindest teilweise) Reflektion der Hochfrequenz-Zwischensignale im Bereich des Kopplers erfolgen. Beispielsweise erfolgt eine kontinuierliche Reflektion der Hochfrequenz-Zwischensignale während der Ausbreitung durch den Koppler. Weiterhin kann der Sekundär-Combiner derart ausgelegt sein, dass eine (gezielte) weitere (zumindest teilweise) Reflektion des Hochfrequenz-Ausgangssignals im im Wesentlichen länglichen Leitungsabschnitts des Sekundär-Combiners (beispielsweise an einem dem Koppler abgewandten Ende) erfolgt. Das erste reflektierte Hochfrequenz-Signal und (zumindest) das weitere reflektierte Hochfrequenz-Signal kompensieren sich dann zumindest teilweise, beispielsweise im Übergangsbereich von dem jeweiligen Primär-Combiner und dem Sekundär-Combiner.

Gemäß einer bevorzugten Ausgestaltung der unterschiedlichen Aspekte der Erfindung ist der im Wesentlichen längliche Leitungsabschnitt des Sekundär-Combiners mittig auf dem Koppler des Sekundär-Combiners angeordnet (beispielsweise im Zentrum eines kreisscheibenförmigen Kopplers des Sekundär-Combiners) und vorzugsweise sind die Primär-Combiner um den im Wesentlichen länglichen Abschnitt des Sekundär-Combiners herum auf dem Koppler des Sekundär-Combiners angeordnet.

Hierdurch wird ein weiterhin verringerter Raumbedarf der Combiner-Anordnung bei hohen Wirkungsgraden erreicht. Beispielsweise sind die Primär-Combiner kreisförmig um den im Wesentlichen länglichen Leitungsabschnitt des Sekundär-Combiners herum angeordnet. Beispielsweise sind die Primär-Combiner in gleichen Abständen zueinander und/oder zum im Wesentlichen länglichen Leitungsabschnitt des Sekundär-Combiners angeordnet.

Beispielsweise lässt sich der Koppler des Sekundär-Combiners in eine ganze Zahl "n" im Wesentlichen kongruenter Kopplersegmente unterteilen, wobei n der Anzahl der Primär-Combiner, das heißt der Anzahl der Hochfrequenz-Zwischensignale, entspricht. Beispielsweise sind die Primär-Combiner jeweils in einem der n kongruenten Kopplersegmente mit dem Sekundär-Combiner verbunden. Die Combiner-Anordnung ist also beispielsweise um eine n-zählige Drehachse drehsymmetrisch (beispielsweise um den im Wesentlichen länglichen Leitungsabschnitt des Sekundär-Combiners).

Gemäß einer bevorzugten Ausgestaltung der unterschiedlichen Aspekte der Erfindung sind die Primär-Combiner und/oder der Sekundär-Combiner zumindest abschnittsweise als Koaxialleiter ausgebildet.

Insbesondere bei Frequenzen im VHF-Bereich können über Koaxialleiter Combiner-Anordnungen mit hohen Wirkungsgraden erzielt werden. Die Primär-Combiner und/oder der Sekundär-Combiner können beispielsweise abschnittsweise als Luftleiter ausgebildet sein. Hierunter wird eine koaxial aufgebaute elektrische Leitung verstanden, die zur Halterung des Innenleiters jedenfalls abschnittsweise keine dielektrischen Stützen sondern Luft enthält. Hierdurch kann aufgrund der sehr genau bekannten Permittivität von Luft durch genaue mechanische Abmessungen (beispielsweise Innendurchmesser des Außenleiters Durchmesser des Innenleiters) der Leitungswellenwiderstand genau eingestellt werden.

Gemäß einer bevorzugten Ausgestaltung der unterschiedlichen Aspekte der Erfindung sind die Primär-Combiner und/oder der Sekundär-Combiner zumindest abschnittsweise dielektrisch belastet. Beispielsweise ist hierzu ein Dielektrikum vorgesehen. Das Dielektrikum kann beispielsweise Polytetrafluorethylen (PTFE) sein.

Insbesondere weist der als Koaxialleiter ausgebildete im Wesentlichen längliche Leitungsabschnitt des Sekundär-Combiners ein zwischen Außenleiter und Innenleiter angeordnetes Dielektrikum auf. Beispielsweise weist das Dielektrikum abwechselnde Bereiche unterschiedlicher Dicke auf. Hierdurch können besonders vorteilhaft gewünschte Eigenschaften des im Wesentlichen länglichen Leitungsabschnitts, beispielsweise eine gezielte Anpassung des Leitungswellenwiderstandes, erreicht werden. Durch die abschnittsweise Belastung der Primär-Combiner mit einem Dielektrikum kann insbesondere die Länge der Primär-Combiner reduziert werden, sodass insbesondere eine sehr kompakte Combiner-Anordnung bereitgestellt werden kann.

Gemäß einer bevorzugten Ausgestaltung der unterschiedlichen Aspekte der Erfindung weist der Koppler des Sekundär-Combiners einen Hohlraum mit einem darin angeordneten inneren Koppelleiter auf. Hierzu kann der Koppler des Sekundär-Combiners beispielsweise ein Gehäuse aufweisen. Der Hohlraum kann dann beispielsweise durch das Gehäuse, welches beispielsweise ein scheibenförmiges oder dosenförmiges Gehäuse sein kann, bereitgestellt werden. Wie bereits in Zusammenhang mit dem Koppler des Sekundär-Combiners ausgeführt, kann das Gehäuse beispielsweise eine Kreisscheibe oder eine mehreckige Scheibe sein. Die Geometrie des Gehäuses und des inneren Koppelleiters sind beispielsweise aneinander angepasst. Der innere Koppelleiter kann also beispielsweise ebenfalls scheibenförmig ausgeführt sein, also eine innere Koppelscheibe sein, beispielsweise eine Kreisscheibe oder eine mehreckige Scheibe, wie bereits in Zusammenhang mit dem Koppler des Sekundär-Combiners ausgeführt. Dadurch lässt sich auf einfache Weise der Koppler als koplanarer Wellenleiter ausbilden, wobei der innere Koppelleiter als Innenleiter fungiert und das Gehäuse als Außenleiter. Hierdurch wird eine elektromagnetische Abschirmung erreicht, eine Abstrahlung von Hochfrequenz-Strahlung vermieden und somit ein Leistungsverlust verringert.

Gemäß einer bevorzugten Ausgestaltung ist der Koppler des Sekundär-Combiners als Parallelplattenleiter ausgebildet. Dabei sind die Leiter des Kopplers des Sekundär-Combiners zumindest abschnittsweise als im Wesentlichen parallel verlaufende Platten ausgebildet. Weist der Koppler des Sekundär-Combiners beispielsweise ein Gehäuse mit einem darin angeordneten Koppelleiter auf, verlaufen die als Außenleiter dienenden Gehäuseabschnitte des Gehäuses und der als Innenleiter dienende Koppelleiter beispielsweise im Wesentlichen parallel zueinander, um einen Koppler zu bilden, welcher beispielsweise als abgeschirmter Parallelplattenleiter angesehen werden kann.. Das heißt, es ist keine konische Gehäuseseite (beispielsweise eine konische Bodenplatte des Gehäuses) vorgesehen, um eine Anpassung des Leitungswellenwiderstands zu erhalten. Vielmehr ist eine Anpassung des Leitungswellenwiderstands im Koppler des Sekundär-Combiners nicht notwendig, da Reflektionen, welche durch eine fehlende Anpassung des Leitungswellenwiderstands hervorgerufen werden, beispielsweise durch gezielte weitere Reflektionen kompensiert werden können, wie bereits beschrieben. Grundsätzlich kann aber zusätzlich auch eine konische Gehäuseseite vorgesehen sein, um eine Anpassung des Leitungswellenwiderstandes zu erreichen.

Gemäß einer bevorzugten Ausgestaltung der unterschiedlichen Aspekte der Erfindung weisen die Primär-Combiner zumindest teilweise, vorzugsweise jeweils einen Kollektorabschnitt mit Anschlüssen zur Einkopplung der Hochfrequenz-Eingangssignale auf.

Die Kollektorabschnitte sind beispielsweise im Wesentlichen länglich ausgebildet. Die Anschlüsse zur Einkopplung der Hochfrequenz-Eingangssignale sind beispielsweise für eine lösbare Verbindung eingerichtet. Beispielsweise ermöglichen die Anschlüsse eine Verbindung von Koaxialkabeln mit dem Kollektorabschnitt des jeweiligen Primär-Combiners. Vorzugsweise entspricht die Anzahl der Anschlüsse der Anzahl der Hochfrequenz-Eingangssignale. Die Kollektorabschnitte sind beispielsweise jeweils an einem von dem Koppler des Sekundär-Combiners abgewandten Ende des jeweiligen Primär-Combiners angeordnet. Dies ermöglicht eine einfache Zugänglichkeit der Anschlüsse.

Gemäß einer bevorzugten Ausgestaltung der unterschiedlichen Aspekte der Erfindung weisen die Kollektorabschnitte der Primär-Combiner zumindest teilweise, vorzugsweise jeweils einen insbesondere scheibenförmigen Koppler zum Zusammenführen der Hochfrequenz-Eingangssignale auf.

Hierdurch lässt sich ein Zusammenführen der Eingangssignale im jeweiligen Primär-Combiner ohne hohe Kombinationsverluste realisieren. Im Unterschied zu dem Koppler des Sekundär-Combiners ist die charakteristische geometrische Ausdehnung des jeweiligen Kopplers der Primär-Combiner im Vergleich zu der Wellenlänge der Hochfrequenz-Eingangssignale vernachlässigbar. Dadurch können die Koppler der Primär-Combiner als punktförmig angenommen werden.

Für den Fall, dass die Koppler der Primär-Combiners (kreis-)scheibenförmig ausgebildet sind, beträgt der Radius der scheibenförmigen Koppler der Primär-Combiner beispielsweise höchstens 7%, bevorzugt höchstens 5%, weiter bevorzugt höchstens 2% der Wellenlänge der Hochfrequenz-Eingangssignale. Beispielsweise beträgt der Radius der scheibenförmigen Koppler der Primär-Combiner höchstens 30 cm, bevorzugt höchstens 20cm, besonders bevorzugt höchstens 10cm.

Gemäß einer bevorzugten Ausgestaltung der unterschiedlichen Aspekte der Erfindung weisen die Primär-Combiner zur Anpassung des Leitungswellenwiderstandes zumindest teilweise, vorzugsweise jeweils einen Transformatorabschnitt auf, wobei die Anpassung des Leitungswellenwiderstandes vorzugsweise stufig erfolgt.

Dadurch kann der Leitungswellenwiderstand der Primär-Combiner derart angepasst werden, dass eine Reflektion des jeweiligen Hochfrequenz-Zwischensignals im Übergangsbereich des jeweiligen Primär-Combiners zum Sekundär-Combiner reduziert oder vermieden wird. Die Transformatorabschnitte können sich beispielsweise jeweils an die jeweiligen Kollektorabschnitte anschließen.

Aufgrund der Anbindung mehrerer Hochfrequenz-Eingangssignale (beispielsweise mittels n Kabel am Kollektor), sieht jedes dieser Kabel an dem Kollektor einen Eingangswellenwiderstand von 1/n des Leitungswellenwiderstands der Kabel (beispielsweise 50Ω/n]. Dieser Leitungswellenwiderstand muss nun wieder auf den gewünschten Ausgangswellenwiderstand (beispielsweise 50Ω) transformiert werden. Dies kann über den Transformatorabschnitt erfolgen. Dieser ist beispielsweise ein λ/4-Transformator. Ein λ/4-Transformator ist im Allgemeinen ein Leiter mit im Wesentlichen der Länge λ/4 und mit einem Wellenwiderstand der Wurzel aus dem Produkt von Eingangswellenwiderstand und Ausgangswellenwiderstand (also beispielsweise Wurzel(50λ/n x 50Ω)).

Durch eine zusätzliche stufige Anpassung, auch "Stepped-Impedance-Design" genannt, beispielsweise durch eine stufenförmige Änderung des Durchmessers des Innen oder Außenleiters, kann der Platzbedarf der Combiner-Anordnung weiterhin verringert werden, da die Primär-Combiner kürzer ausgeführt werden können.

Bevorzugt sind die Transformatorabschnitte der Primär-Combiner zumindest teilweise, vorzugsweise jeweils zumindest abschnittsweise dielektrisch belastet. Beispielsweise ist hierzu ein Dielektrikum vorgesehen. Insbesondere weisen die als Koaxialleiter ausgebildeten Transformatorabschnitte der Primär-Combiner jeweils ein zwischen Außenleiter und Innenleiter angeordnetes Dielektrikum auf. Durch die abschnittsweise Belastung der Transformatorabschnitte der Primär-Combiner mit einem Dielektrikum kann insbesondere die Länge der Primär-Combiner reduziert werden.

Gemäß einer bevorzugten Ausgestaltung der unterschiedlichen Aspekte der Erfindung weisen die Primär-Combiner zumindest teilweise, vorzugsweise jeweils integrierte, vorzugsweise bidirektionale Richtkoppler auf.

Durch die Richtkoppler kann die Ausgangsleitung der Primär-Combiner und/oder die Stärke eines möglicherweise von dem Sekundär-Combiner reflektierten Signals gemessen werden. Die Richtkoppler können sich beispielsweise jeweils an die jeweiligen Transformatorabschnitte anschließen.

Gemäß einer bevorzugten Ausgestaltung der unterschiedlichen Aspekte der Erfindung ist die Combiner-Anordnung zum Bereitstellen eines Hochfrequenz-Ausgangssignals mit einer Leistung von mindestens 50kW, bevorzugt mindestens 80kW, besonders bevorzugt mindestens 150kW ausgelegt.

Es hat sich gezeigt, dass die Combiner-Anordnung das Zusammenführen von Hochfrequenz-Eingangssignalen zu einem Hochfrequenz-Ausgangssignal mit solchen hohen Leistungen auf platzsparende Weise mit einem hohen Wirkungsgrad ermöglicht. Damit ist es beispielsweise möglich die benötigte Hochfrequenz-Leistung für Teilchenbeschleuniger zur Verfügung zu stellen.

Insofern wird als weiterer Aspekt der Erfindung eine Verwendung der Combiner-Anordnung gemäß dem ersten Aspekt zum Bereitstellen eines Hochfrequenz-Ausgangssignals mit einer Leistung von mindestens 50kW, bevorzugt mindestens 80kW, besonders bevorzugt mindestens 150kW offenbart.

Gemäß einer bevorzugten Ausgestaltung der unterschiedlichen Aspekte der Erfindung ist die Combiner-Anordnung zum Zusammenführen von Hochfrequenz-Eingangssignalen, insbesondere gleicher Phase und/oder gleicher Amplitude, mit einer Leistung von mindestens 1kW, bevorzugt mindestens 2kW, besonders bevorzugt mindestens 2,5kW ausgelegt.

Wie bereits dargestellt, ermöglicht die Combiner-Anordnung vorteilhaft für das Zusammenführen von Hochfrequenz-Eingangssignalen mit solchen hohen Leistungen auf platzsparende Weise mit einem hohen Wirkungsgrad. Somit können entsprechend hohen Leistungen für die Hochfrequenz-Ausgangssignale erreicht werden.

Insofern wird als weiterer Aspekt der Erfindung eine Verwendung der Combiner-Anordnung gemäß dem ersten Aspekt zum Zusammenführen von Hochfrequenz-Eingangssignalen, insbesondere gleicher Phase und/oder gleicher Amplitude, mit einer Leistung von mindestens 1kW, bevorzugt mindestens 2kW, besonders bevorzugt mindestens 2,5kW offenbart.

Gemäß einer bevorzugten Ausgestaltung der unterschiedlichen Aspekte der Erfindung ist die Combiner-Anordnung zum Zusammenführen von Hochfrequenz-Eingangssignalen mit einer Frequenz von mindestens 30MHz, bevorzugt mindestens 50MHz, besonders bevorzugt mindestens 70MHz und/oder höchstens 500MHz, bevorzugt höchstens 300MHz, besonders bevorzugt höchstens 100MHz ausgelegt.

Die Hochfrequenz-Zwischensignale und das Hochfrequenz-Ausgangssignal besitzen dann beispielsweise ebenfalls eine Frequenz in diesem Bereich, beispielswiese die gleiche Frequenz wie die Hochfrequenz-Eingangssignale. Die Combiner-Anordnung eröffnet insbesondere in diesem Hochfrequenz-Bereich (insbesondere im unteren VHF-Bereich) die Möglichkeit, Hochfrequenz-Eingangssignale mit vergleichsweise großen Wellenlängen auf platzsparende Weise mit einem hohen Wirkungsgrad zusammenzuführen. Beispielsweise wird eine Frequenz von etwa 352 MHz, etwa 118MHz oder etwa 72MHz (beispielsweise 72,3MHz) verwendet.

Insofern wird als weiterer Aspekt der Erfindung eine Verwendung der Combiner-Anordnung gemäß dem ersten Aspekt zum Zusammenführen von Hochfrequenz-Eingangssignalen mit einer Frequenz von mindestens 30MHz, bevorzugt mindestens 50MHz, besonders bevorzugt mindestens 70MHz und/oder höchstens 500MHz, bevorzugt höchstens 300MHz, besonders bevorzugt höchstens 100MHz offenbart.

Gemäß einer bevorzugten Ausgestaltung der unterschiedlichen Aspekte der Erfindung sind mindestens vier, vorzugsweise mindestens sechs Primär-Combiner zum Zusammenführen der jeweils mindestens zwei, vorzugsweise mindestens fünf, besonders bevorzugt mindestens zehn Hochfrequenz-Eingangssignale zum jeweiligen Hochfrequenz-Zwischensignal vorgesehen.

Die Wahl der Anzahl der Primär-Combiner, die auch die Anzahl der zusammenzuführenden Hochfrequenz-Zwischensignale bestimmt, und die Wahl der Anzahl der zusammenzuführenden Hochfrequenz-Eingangssignale pro Primär-Combiner muss bei der Auslegung der Combiner-Anordnung berücksichtigt werden. Es hat sich gezeigt, dass eine entsprechende Anzahl vorteilhaft in Bezug auf eine kompakte Bauform und geringe Kombinationsverluste ist.

Gemäß einer bevorzugten Ausgestaltung der unterschiedlichen Aspekte der Erfindung sind der Primär-Combiner und/oder der Sekundär-Combiner, insbesondere der Koppler des Sekundär-Combiners zumindest teilweise aus Kupfer und/oder Aluminium hergestellt.

Aufgrund ihrer hohen elektrischen Leitfähigkeit sind Kupfer und Aluminium besonders geeignet, um eine Combiner-Anordnung mit einem hohen Wirkungsgrad wirtschaftlich herzustellen. Beispielsweise ist der innenliegende Koppelleiter des Kopplers des Sekundär-Combiners aus Aluminium oder Kupfer hergestellt. Ebenfalls können weitere Teile des Kopplers des Sekundär-Combiners, beispielsweise ein um den innenliegenden Koppelleiter angeordnetes Gehäuse aus Aluminium oder Kupfer hergestellt sein. Ebenfalls können weitere Teile der Combiner-Anordnung aus Aluminium oder Kupfer hergestellt sein, beispielsweise der Primär-Combiner oder Teile hiervon.

Besonders vorteilhaft sind die Innenleiter der als Koaxialleiter ausgebildeten Primär-Combiner und/oder der Innenleiter des als Koaxialleiter ausgebildeten Sekundär-Combiners, das heißt insbesondere der innere Koppelleiter des Kopplers des Sekundär-Combiners, aus Kupfer hergestellt. Beispielsweise sind die Innenleiter aneinander gelötet.

Besonders vorteilhaft sind die Außenleiter der als Koaxialleiter ausgebildeten Primär-Combiner und/oder der Außenleiter des als Koaxialleiter ausgebildeten Sekundär-Combiners, das heißt insbesondere das Gehäuse des Kopplers des Sekundär-Combiners, aus Aluminium hergestellt.

Die Combiner-Anordnung gemäß dem ersten Aspekt kann in einem Schaltschrank angeordnet sein. Durch die Combiner-Anordnung gemäß dem ersten Aspekt kann diese nämlich derart kompakt und vorteilhaft gebaut werden, dass die Combiner-Anordnung in einem Schaltschrank angeordnet werden kann und die Hochfrequenz-Eingangssignale auf der Frontseite des Schaltschranks eingekoppelt werden können bzw. das Hochfrequenz-Ausgangssignal auf der Frontseite des Schaltschranks ausgekoppelt werden kann.

In Bezug auf ein System gemäß dem zweiten Aspekt kann eine Verstärkereinheit beispielsweise ein oder mehrere Transistoren, beispielsweise ein oder mehrere (beispielsweise vier) Transistorpaare in Gegentaktschaltung, aufweisen. Die Signale der Transistoren können beispielsweise in Planartechnik (beispielsweise über Wilkinson oder Hybrid-Combiner) zusammengeführt sein, um ein Hochfrequenz-Eingangssignal für die Combiner-Anordnung bereitzustellen.

Die Verstärkereinheiten können beispielsweise in einem oder mehreren Schaltschränken angeordnet sein.

Bezüglich der Vorteile und weiterer Ausgestaltungen des Systems gemäß dem zweiten Aspekt und dem Verfahren gemäß dem dritten Aspekt wird insbesondere auf die Beschreibung der Combiner-Anordnung gemäß dem ersten Aspekt und deren Ausgestaltungen verwiesen.

Insbesondere soll durch die vorherige (und folgende) Beschreibung von Mitteln zur Durchführung eines Verfahrensschrittes der entsprechende Verfahrensschritt offenbart sein. Ebenfalls sollen durch die Offenbarung von Verfahrensschritten auch entsprechende Mittel oder Einrichtungen zur Durchführung der Verfahrensschritte offenbart sein.

Die oben beschriebenen Ausführungsbeispiele und beispielhaften Ausgestaltungen aller Aspekte der vorliegenden Erfindung sollen auch in allen Kombinationen miteinander offenbart verstanden werden.

Weitere vorteilhafte beispielhafte Ausgestaltungen der unterschiedlichen Aspekte sind der folgenden detaillierten Beschreibung einiger beispielhafter Ausführungsformen der Aspekte, insbesondere in Verbindung mit den Figuren zu entnehmen. Die der Anmeldung beiliegenden Figuren sollen jedoch nur dem Zwecke der Verdeutlichung, nicht aber zur Bestimmung des Schutzbereiches der Erfindung dienen. Die beiliegenden Zeichnungen sind nicht notwendigerweise maßstabsgetreu und sollen lediglich das allgemeine Konzept der vorliegenden Aspekte beispielhaft widerspiegeln. Insbesondere sollen Merkmale, die in den Figuren enthalten sind, keineswegs als notwendiger Bestandteil der vorliegenden Erfindung erachtet werden.

Es zeigen:
- Fig. 1a: eine Längsschnittdarstellung eines Ausführungsbeispiels einer erfindungsgemäßen Combiner-Anordnung;
- Fig. 1b: eine Draufsicht des Ausführungsbeispiels aus Fig. 1a;
- Fig. 2: eine Teilquerschnittsdarstellung eines weiteren Ausführungsbeispiels einer erfindungsgemäßen Combiner-Anordnung;
- Fig. 3: zwei Darstellungen der inneren Koppelscheibe und
- Fig. 4: die Längsschnittdarstellung des Ausführungsbeispiels der Combiner-Anordnung aus Fig.1 angeordnet in einem Schaltschrank.

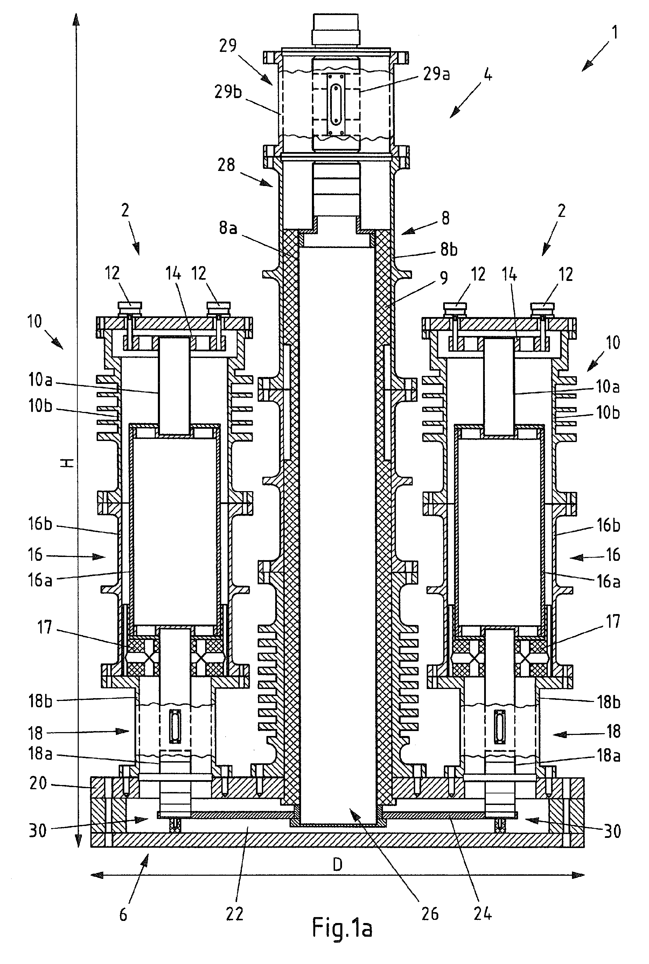

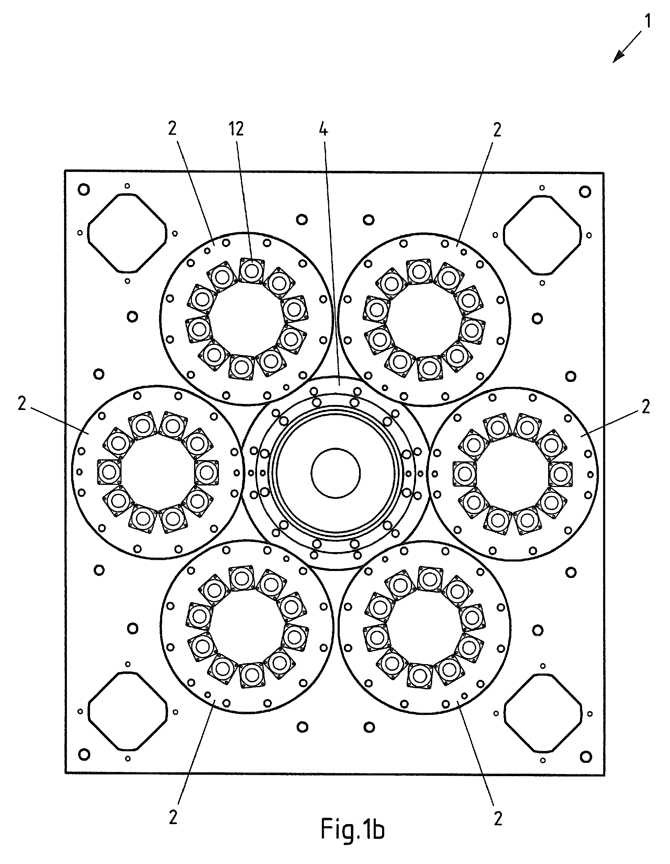

Fig. 1a zeigt eine Längsschnittdarstellung eines Ausführungsbeispiels einer erfindungsgemäßen Combiner-Anordnung 1, während Fig. 1b eine Draufsicht des Ausführungsbeispiels aus Fig. 1a zeigt. Die Combiner-Anordnung 1 dient zum Zusammenführen mehrerer Hochfrequenz-Eingangssignale zu einem Hochfrequenz-Ausgangssignal und ist als Radial-Combiner ausgebildet. Die gezeigt Combiner-Anordnung 1 kann Hochfrequenz-Signale einer Frequenz von etwa 72 MHz, was einer Wellenlänge von etwa 4,16m entspricht, zusammenführen. Die Combiner-Anordnung kann in diesem Fall insgesamt 60 Hochfrequenz-Eingangssignale von 2,5kW zu einem Hochfrequenz-Ausgangssignal von 150kW zusammenführen.

Die Combiner-Anordnung 1 weist in diesem Fall hierzu sechs Primär-Combiner 2 auf, von denen zwei Primär-Combiner in der Schnittdarstellung in Fig.1 zu sehen sind. Die Primär-Combiner 2 dienen jeweils dem Zusammenführen von jeweils zehn Hochfrequenz-Eingangssignalen zu jeweils einem Hochfrequenz-Zwischensignal, sodass die Primär-Combiner 2 insgesamt sechs Hochfrequenz-Zwischensignale bereitstellen.

Zudem weist die Combiner-Anordnung 2 einen Sekundär-Combiner 4 auf, welcher zum Zusammenführen der Hochfrequenz-Zwischensignale der Primär-Combiner 2 zu einem Hochfrequenz-Ausgangssignal dient. Der Sekundär-Combiner 4 weist einen Koppler 6 zum Zusammenführen der Hochfrequenz-Zwischensignale der Primär-Combiner 2 auf. Der Koppler 6 ist in diesem Fall scheibenförmig ausgebildet. Grundsätzlich sind jedoch auch andere Geometrien denkbar. Zudem weist der Sekundär-Combiner einen länglichen Leitungsabschnitt 8 auf. Der längliche Leitungsabschnitt 8 des Sekundär-Combiners 4 ist dabei im Bereich 26 mittig und senkrecht auf dem scheibenförmigen Koppler 6 des Sekundär-Combiners 4 angeordnet. Der längliche Leitungsabschnitt 8 des Sekundär-Combiners 4 ist mit einem Dielektrikum belastet und weist einem Dielektrikum 9 auf, welches sich über einen Großteil des länglichen Leitungsabschnitts 8 des Sekundär-Combiners 4 erstreckt. Das Dielektrikum 9 ist zwischen dem Innenleiter 8a und dem Außenleiter 8b des länglichen Leitungsabschnitts 8 des Sekundär-Combiners 4 angeordnet. Das Dielektrikum 9 weist in diesem Fall abwechselnde Bereiche unterschiedlicher Dicke auf. Das Dielektrikum 9 ist in diesem Fall Polytetrafluorethylen. Durch das Dielektrikum 9 kann die Länge des länglichen Leitungsabschnitts 8 reduziert werden.

Der Sekundär-Combiner 4 weist eine Höhe H von etwa 1,20m auf. Der Durchmesser D des scheibenförmigen Kopplers 6 des Sekundär-Combiners 4 weist einen Durchmesser von etwa 70cm auf.

Die Primär-Combiner 2 sind ebenfalls jeweils länglich und zylindrisch ausgebildet und verlaufen parallel zueinander und zum länglichen und zylindrischen Leitungsabschnitt 8 des Sekundär-Combiners 4. Zudem stehen die Primär-Combiner 2 jeweils im Wesentlichen senkrecht auf dem scheibenförmigen Koppler 6 des Sekundär-Combiners 4. Die Primär-Combiner 2 sind um den länglichen Abschnitt 8 des Sekundär-Combiners 4 herum auf dem scheibenförmigen Koppler 6 des Sekundär-Combiner 4 angeordnet (wie in Fig. 1b zu erkennen ist).

Sowohl die Primär-Combiner 2 als auch der Sekundär-Combiner 4 sind durchgängig als Koaxialleiter ausgebildet. Das heißt, die einzelnen Abschnitte der Primär-Combiner 2 und die einzelnen Abschnitte des Sekundär-Combiners 4 weisen durchgängig Innenleiter (10a, 16a, 18a, 24, 8a, 29a) und Außenleiter (10b, 16b, 18b, 20, 8b, 29b) auf.

Die Primär-Combiner 2 weisen jeweils einen Kollektorabschnitt 10 mit Anschlüssen 12 zur Einkopplung der Hochfrequenz-Eingangssignale auf. Die Anschlüsse 12 sind jeweils als Koaxial-Verbinder ausgebildet und ermöglichen die Anbindung von Koaxialkabeln (nicht dargestellt) zur Einkopplung der Hochfrequenz-Eingangssignale. Die Primär-Combiner 2 weisen jeweils zehn der Anschlüsse 12 auf, von denen jeweils nur zwei in der Schnittdarstellung gezeigt sind. Die Anschlüsse 12 sind beispielsweise kreisförmig angeordnet. Die Kollektorabschnitte 10 der Primär-Combiner 2 weisen jeweils einen Koppler 14 zum Zusammenführen der Hochfrequenz-Eingangssignale auf, wobei die Koppler 14 hier ebenfalls scheibenförmig ausgebildet sind. Der Radius als eine charakteristische geometrische Ausdehnung der jeweiligen scheibenförmigen Koppler 14 der Primär-Combiner 2 ist mit etwa 7cm im Vergleich zu der Wellenlänge von etwa 4,16m der Hochfrequenz-Eingangssignale (weniger 2% der Wellenlänge) vernachlässigbar, sodass die scheibenförmigen Koppler 14 der Primär-Combiner 2 als punktförmig angenommen werden können, sodass das Verhalten der Hochfrequenz-Signal analytisch berechenbar ist.

Die Primär-Combiner 2 weisen zur Anpassung des Leitungswellenwiderstandes jeweils einen Transformatorabschnitt 16 auf. Die Transformatorabschnitte 16 schließen sich jeweils unmittelbar an die Kollektorabschnitte 10 an und sind hier über eine Flanschverbindung mit den Kollektorabschnitten 10 verbunden. Durch die Transformatorabschnitte 16 kann der Leitungswellenwiderstand derart angepasst werden, dass eine möglichst geringe (oder im Optimalfall keine) Reflektion der Hochfrequenz-Zwischensignale zurück in den Primär-Combinern 2 oder in davor angeordnete Bauteile erfolgt. Die Transformatorabschnitte 16 sind hier durch koaxiale Transformatoren (etwa λ/4-Transformatoren) realisiert. Zudem sind die Transformatorabschnitte 16 durch den Übergang von Innenleiter 10 auf Innenleiter 16a stufig realisiert, was letztendlich zu einer Länge der Transformatorabschnitte 16 von weniger als 1/4 der Vakuumwellenlänge λ führt. Zudem weisen die Transformatorabschnitte 16 jeweils einen Bereich mit einem Dielektrikum 17 auf, welches jeweils in dem dem scheibenförmigen Koppler 6 des Sekundär-Combiners zugewandten Bereich des Transformatorabschnitts 16 angeordnet ist. Das Dielektrikum 17 ist in diesem Fall Polytetrafluorethylen. Hierdurch kann insbesondere eine mechanische Stütze ermöglicht werden und/oder die Länge der Primär-Combiner 2 reduziert werden.

An die Transformatorabschnitte 16 der Primär-Combiner 2 schließen sich jeweils unmittelbar bidirektionale Richtkoppler 18 an. Durch die Richtkoppler 18 kann beispielsweise zu Überwachungszwecken einerseits ein Teil des in Richtung des Sekundär-Combiners 4 geleiteten Hochfrequenz-Zwischensignals gemessen werden. Andererseits kann die Stärke eines möglicherweise von dem Sekundär-Combiner 4 zurück in den Primär-Combiner 2 reflektierten Signals gemessen werden. Ebenfalls ist am vom scheibenförmigen Koppler 6 abgewandten Ende 28 des länglichen Leitungsabschnitts 8 ein bidirektionaler Richtkoppler 29 vorgesehen.

Die Richtkoppler 18 sind jeweils unmittelbar mit dem scheibenförmigen Koppler 6 des Sekundär-Combiners 4 verbunden. Im Bereich 30 werden die Hochfrequenz-Zwischensignale von den Primär-Combinern 2 auf den scheibenförmigen Koppler 6 des Sekundär-Combiners 4 übertragen. Der scheibenförmige Koppler 6 des Sekundär-Combiners 4 weist ein scheibenförmiges Gehäuse 20 mit einem Hohlraum 22 und einem darin angeordneten inneren Koppelleiter in Form einer Koppelscheibe 24 auf, welche einen abgeschirmten Parallelplattenleiter bilden. Die innere Koppelscheibe 24 dient als Innenleiter des scheibenförmigen Kopplers 6. Im Unterschied zu den kleineren scheibenförmigen Kopplern 14 der Primär-Combiner 2 ist der Radius (35cm) als eine charakteristische geometrische Ausdehnung des größeren scheibenförmigen Kopplers 6 des Sekundär-Combiners 4 im Vergleich zu der Wellenlänge (4,16m) der Hochfrequenz-Eingangssignale und/oder des Hochfrequenz-Ausgangssignals (mehr als 7% der Wellenlänge) nicht vernachlässigbar. Das heißt, dass die Ausdehnung insbesondere für geringe Kombinationsverluste bzw. einen hohen Wirkungsgrad keine nur untergeordnete Bedeutung besitzt.

Aufgrund der komplexen Geometrie des scheibenförmigen Kopplers 6 kann jedoch keine Geometrie zur Anpassung (beispielsweise des Leitungswellenwiderstandes) analytisch errechnet werden, um Reflektionen der Hochfrequenz-Zwischensignale während der Propagation durch den scheibenförmigen Koppler 6 (das heißt vom Bereich 30 zum Bereich 26) zu vermeiden. Allerdings ist der Sekundär-Combiner 4 derart ausgelegt, dass eine zumindest teilweise Kompensation von im Sekundär-Combiner 4 bei der Ausbreitung im scheibenförmigen Koppler 6 kontinuierlich reflektierten Hochfrequenz-Signalen erreicht wird. Dabei kompensieren sich einerseits die im scheibenförmigen Koppler 6 (teilweise) unerwünscht reflektierte Hochfrequenz-Zwischensignale und andererseits das an einem dem scheibenförmigen Koppler 6 abgewandten Ende 28 des länglichen Leitungsabschnitts 8 des Sekundär-Combiners 6 (teilweise) gezielt reflektierte Hochfrequenz-Ausgangssignal zumindest teilweise. In diesem Fall wird die Reflektion durch die stufenförmige Verringerung des Durchmessers des Innenleiters 8a im Bereich 28 erreicht. Grundsätzlich ist auch denkbar, dass die Reflektion durch eine andere geometrische Anpassung, beispielsweise eine Änderung des Durchmessers des Außenleiters 8b, oder durch das Vorsehen eines Dielektrikums im Bereich 28 erreicht wird. Die Kompensation, das heißt hier die destruktive Interferenz der reflektierten Hochfrequenz-Signale erfolgt in diesem Fall im Bereich 30. Auf diese Weise kann erreicht werden, dass eine Reflektion von Signalen zurück in die Primär-Combiner 2 zumindest teilweise unterbunden wird.

Das Design des Sekundär-Combiners 4 und die Einflüsse der einzelnen Faktoren auf das Design können beispielsweise mittels einer Finite-Elemente-Methode simuliert werden. Dadurch kann beispielsweise bestimmt werden, an welcher Stelle und in welcher Form die gezielte Reflektion der Hochfrequenz-Signale im Bereich 28 erfolgen muss, um die während der Propagation durch den scheibenförmigen Koppler 6 auftretende unerwünschte Reflektion schließlich im Bereich 30 kompensieren zu können.

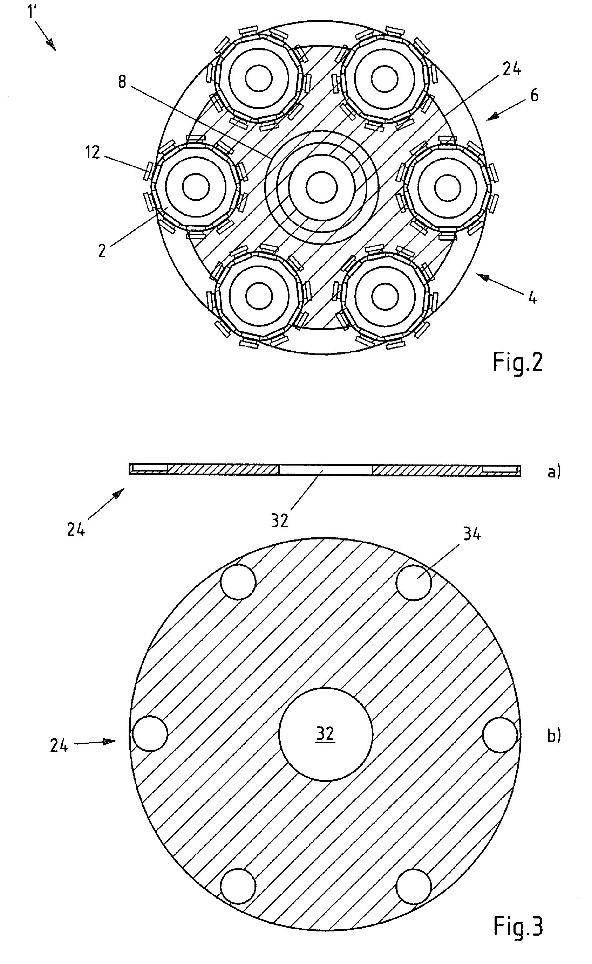

Fig. 2 zeigt eine Teilquerschnittsdarstellung eines weiteren Ausführungsbeispiels einer erfindungsgemäßen Combiner-Anordnung 1'. Die Combiner-Anordnung 1' unterscheidet sich dabei lediglich von der Combiner-Anordnung 1 durch die Anordnung der Anschlüsse 12. Diese sind nicht wie in Fig. 1 gezeigt auf der Oberseite der zylinderförmigen Primär-Combiner 2 sondern seitlich entlang der Umfangslänge der zylinderförmigen Primär-Combiner 2 angeordnet. Im Übrigen ist die Combiner-Anordnung 1'identisch zu der Combiner-Anordnung 1. In Fig. 2 ist jedoch gut die kreisförmige, gleichmäßige Anordnung der sechs Primär-Combiner 2 um den länglichen Leitungsabschnitt 8 auf dem scheibenförmigen Koppler 6 zu erkennen. Zur besseren Verdeutlichung der inneren Koppelscheibe 24, ist diese in Fig. 2 mit einer Schraffur betont dargestellt.

Fig. 3 zeigt hierzu Darstellungen der inneren Koppelscheibe 24 im Querschnitt (Fig. 3a) und in Draufsicht (Fig. 3b). Die innere Koppelscheibe 24 ist kreiszylindrisch und weist mittig eine Ausnehmung 32 auf. In diesem Bereich wird der längliche Leitungsabschnitt 8 des Sekundär-Combiners 4 angebunden. Zudem weist die innere Koppelscheibe 24 sechs Aufnahmen 34 auf, welche zur Anbindung der sechs Primär-Combiner 2 dienen. Die innere Koppelscheibe 24 ist hier aus Kupfer hergestellt, während das Gehäuse 20 aus Aluminium hergestellt ist.

Weiterhin sind die Außenleiter (10b, 16b, 18b, 20, 8b, 29b) der Primär-Combiner 2 und des Sekundär-Combiners 4 aus Aluminium hergestellt, während die Innenleiter (10a, 16a, 18a, 24, 8a, 29a) der Primär-Combiner 2 und des Sekundär-Combiners 4 aus Kupfer hegestellt sind.

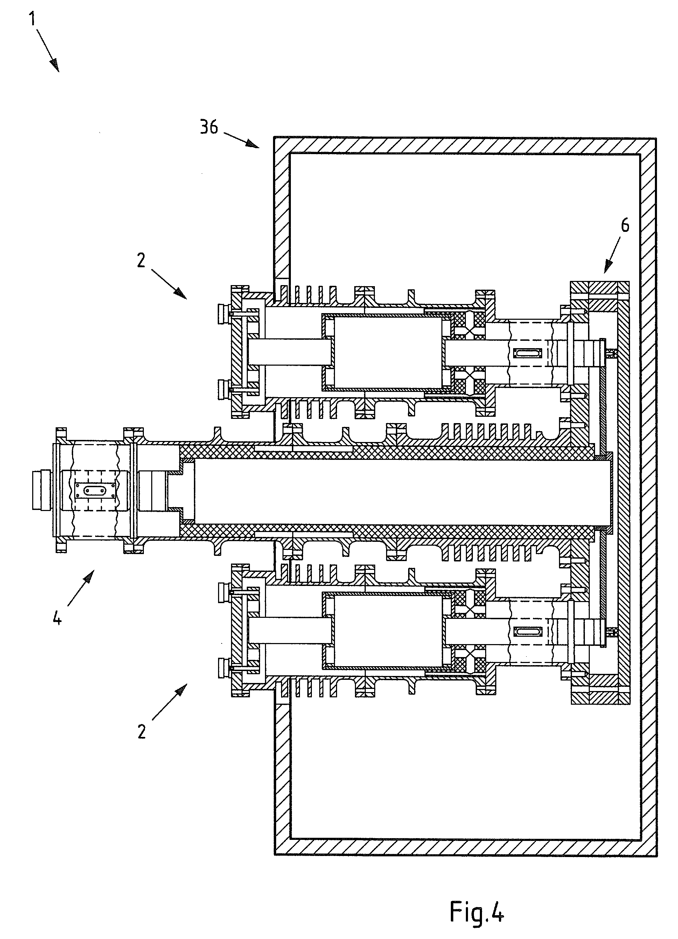

Fig. 4 zeigt eine Längsschnittdarstellung des Ausführungsbeispiels der Combiner-Anordnung 1 aus Fig. 1 angeordnet in einem Schaltschrank 36. Wie zu erkennen ist, kann die Combiner-Anordnung in dem Schaltschrank 36 angeordnet werden. An den vom scheibenförmigen Koppler 6 entfernt liegenden Enden der Primär-Combiner 2 können Koaxialkabel angeschlossen werden, welche der Combiner-Anordnung 1 Hochfrequenz-Eingangssignale von Verstärkereinheiten (nicht dargestellt), welche beispielsweise in anderen Schaltschränken untergebracht sind, zuführen. Ebenfalls kann am vom scheibenförmigen Koppler 6 entfernt liegenden Ende des länglichen Leitungsabschnitts 4 das Hochfrequenz-Ausgangssignal problemlos und leicht zugänglich aus der Combiner-Anordnung 1 ausgekoppelt werden.

## Patentansprüche

1. Combiner-Anordnung zum Zusammenführen mehrerer Hochfrequenz-Eingangssignale zu einem Hochfrequenz-Ausgangssignal umfassend:
- mindestens zwei Primär-Combiner (2) zum Zusammenführen von jeweils mindestens zwei Hochfrequenz-Eingangssignalen zu jeweils einem Hochfrequenz-Zwischensignal und
- einen Sekundär-Combiner (4) zum Zusammenführen der Hochfrequenz-Zwischensignale der Primär-Combiner zu dem Hochfrequenz-Ausgangssignal,
**dadurch gekennzeichnet, dass**
der Sekundär-Combiner einen Koppler (6) zum Zusammenführen der Hochfrequenz-Zwischensignale der Primär-Combiner umfasst.

2. Combiner Anordnung nach Anspruch 1,
wobei der Koppler (6) des Sekundär-Combiners scheibenförmig ausgeführt ist.

3. Combiner-Anordnung nach Anspruch 1 oder 2,
wobei der Sekundär-Combiner (4) insbesondere durch seine Geometrie derart ausgelegt ist, dass eine zumindest teilweise Kompensation von im Sekundär-Combiner reflektierten Hochfrequenz-Signalen erreicht wird.

4. Combiner-Anordnung nach Anspruch 3,
wobei die im Sekundär-Combiner reflektierten Hochfrequenz-Signale durch eine weitere gezielte Reflektion von Hochfrequenz-Signalen im Sekundär-Combiner kompensiert werden.

5. Combiner-Anordnung nach einem der Ansprüche 1 bis 4,
wobei zumindest eine charakteristische geometrische Ausdehnung des Kopplers (6) des Sekundär-Combiners (4) im Vergleich zu der Wellenlänge der Hochfrequenz-Eingangssignale und/oder des Hochfrequenz-Ausgangssignals nicht vernachlässigbar ist.

6. Combiner-Anordnung nach einem der Ansprüche 1 bis 5,
wobei die Primär-Combiner (2) jeweils im Wesentlichen länglich ausgebildet sind, wobei die Primär-Combiner (2) vorzugsweise im Wesentlichen parallel verlaufen und/oder im Wesentlichen senkrecht auf dem Koppler (6) des Sekundär-Combiners (4) stehen.

7. Combiner-Anordnung nach einem der Ansprüche 1 bis 6,
wobei der Sekundär-Combiner (4) einen im Wesentlichen länglichen Leitungsabschnitt (8) aufweist, welcher vorzugsweise im Wesentlichen parallel zu den Primär-Combiner (2) verläuft und/oder im Wesentlichen senkrecht auf dem Koppler (6) des Sekundär-Combiners (4) steht.

8. Combiner-Anordnung nach Anspruch 7,
wobei der im Wesentlichen längliche Leitungsabschnitt (8) des Sekundär-Combiners (4) mittig auf dem Koppler (6) des Sekundär-Combiners (4) angeordnet ist und vorzugsweise die Primär-Combiner (2) um den im Wesentlichen länglichen Abschnitt (8) des Sekundär-Combiners (4) herum auf dem Koppler (6) des Sekundär-Combiners (4) angeordnet sind.

9. Combiner-Anordnung nach einem der Ansprüche 1 bis 8,
wobei die Primär-Combiner (2) und/oder der Sekundär-Combiner (4) zumindest abschnittsweise als Koaxialleiter ausgebildet sind.

10. Combiner-Anordnung nach Anspruch 9,
wobei die Primär-Combiner (2) und/oder der Sekundär-Combiner (4) zumindest abschnittsweise dielektrisch belastet sind.

11. Combiner-Anordnung nach einem der Ansprüche 1 bis 10,
wobei der Koppler (6) des Sekundär-Combiners (4) einen Hohlraum (22) mit einer darin angeordneten inneren Koppelleiter (24) aufweist.

12. Combiner-Anordnung nach Anspruch 11,
wobei der Koppler (6) des Sekundär-Combiners als Parallelplattenleiter ausgebildet ist.

13. Combiner-Anordnung nach einem der Ansprüche 1 bis12,
wobei die Primär-Combiner (2) zumindest teilweise, vorzugsweise jeweils einen Kollektorabschnitt (10) mit Anschlüssen (12) zur Einkopplung der Hochfrequenz-Eingangssignale aufweisen.

14. Combiner-Anordnung nach Anspruch 13,
wobei die Kollektorabschnitte (10) der Primär-Combiner (2) zumindest teilweise, vorzugsweise jeweils einen insbesondere scheibenförmigen Koppler (14) zum Zusammenführen der Hochfrequenz-Eingangssignale aufweisen.

15. Combiner-Anordnung nach einem der Ansprüche 1 bis 14,
wobei die Primär-Combiner (2) zur Anpassung des Leitungswellenwiderstandes zumindest teilweise, vorzugsweise jeweils einen Transformatorabschnitt (16) aufweisen, wobei die Anpassung des Leitungswellenwiderstandes vorzugsweise stufig erfolgt.

16. Combiner-Anordnung nach einem der Ansprüche 1 bis 15,
wobei die Primär-Combiner (2) zumindest teilweise, vorzugsweise jeweils integrierte, vorzugsweise bidirektionale Richtkoppler (18) aufweisen.

17. Combiner-Anordnung nach einem der Ansprüche 1 bis 16,
wobei die Combiner-Anordnung (1,1') zum Bereitstellen eines Hochfrequenz-Ausgangssignals mit einer Leistung von mindestens 50kW, bevorzugt mindestens 80kW, besonders bevorzugt mindestens 150kW ausgelegt ist.

18. Combiner-Anordnung nach einem der Ansprüche 1 bis 17,
wobei die Combiner-Anordnung (1,1') zum Zusammenführen von Hochfrequenz-Eingangssignalen, insbesondere gleicher Phase und/oder gleicher Amplitude, mit einer Leistung von mindestens 1kW, bevorzugt mindestens 2kW, besonders bevorzugt mindestens 2,5kW ausgelegt ist.

19. Combiner-Anordnung nach einem der Ansprüche 1 bis 18,
wobei die Combiner-Anordnung (1,1') zum Zusammenführen von Hochfrequenz-Eingangssignalen mit einer Frequenz von mindestens 30MHz, bevorzugt mindestens 50MHz, besonders bevorzugt mindestens 70MHz und/oder höchstens 500MHz, bevorzugt höchstens 300MHz, besonders bevorzugt höchstens 100MHz ausgelegt ist.

20. Combiner-Anordnung nach einem der Ansprüche 1 bis 19,
wobei mindestens vier, vorzugsweise mindestens sechs Primär-Combiner (2) zum Zusammenführen der jeweils mindestens zwei, vorzugsweise mindestens fünf, besonders bevorzugt mindestens zehn Hochfrequenz-Eingangssignale zum jeweiligen Hochfrequenz-Zwischensignal vorgesehen sind.

21. Combiner-Anordnung nach einem der Ansprüche 1 bis 20,
wobei die Primär-Combiner (2) und/oder der Sekundär-Combiner (4), insbesondere der Koppler (6) des Sekundär-Combiners (2) zumindest teilweise aus Kupfer und/oder Aluminium hergestellt sind.

22. System umfassend
- eine Vielzahl von Verstärkereinheiten zur Erzeugung der Hochfrequenz-Eingangssignale und
- eine Combiner-Anordnung (1,1') nach einem der Ansprüche 1 bis 21.

23. Verfahren zum Zusammenführen mehrerer Hochfrequenz-Eingangssignale zu einem Hochfrequenz-Ausgangssignal, insbesondere mit einer Combiner-Anordnung nach einem der Ansprüche 1 bis 21, umfassend die Schritte:
- Zusammenführen von jeweils mindestens zwei Hochfrequenz-Eingangssignalen zu jeweils einem Hochfrequenz-Zwischensignal über mindestens zwei Primär-Combiner und
- Zusammenführen der Hochfrequenz-Zwischensignale der Primär-Combiner zu dem Hochfrequenz-Ausgangssignal über einen Sekundär-Combiner,
**dadurch gekennzeichnet, dass**
die Hochfrequenz-Zwischensignale der Primär-Combiner über einen Koppler des Sekundär-Combiners zusammengeführt werden.
